# EUROPÄISCHE PATENTSCHRIFT

(11) **EP 4 315 594 B1**
(45) Veröffentlichungstag und Bekanntmachung des Hinweises auf die Patenterteilung: **25.11.2026**
(21) Anmeldenummer: 22714213.0
(22) Anmeldetag: 19.03.2022
(51) Int. Cl.: H02S 20/22, H02S 40/22, H02S 20/00, H02S 40/36, H10F 19/00, H10F 19/80, H10F 77/42

(54) **SOLARZELLENTRÄGER**
SOLAR CELL SUPPORT
SUPPORT DE CELLULE SOLAIRE

(30) Priorität: 22.03.2021 LU 102681
(43) Veröffentlichungstag der Anmeldung: 07.02.2024
(73) Patentinhaber: Schäfer und Hofsäss Gbr, 63322 Rödermark (DE)
(72) Erfinder: HOFSÄSS, Benjamin, 63322 Rödermark (DE); SCHÄFER, Michael, 63322 Rödermark (DE)
(74) Vertreter: Grabovac, Dalibor
(86) Internationale Anmeldenummer: PCT/EP2022/057259
(87) Internationale Veröffentlichungsnummer: WO 2022/200237

(56) Entgegenhaltungen:
- EP-B1- 3 575 673
- WO-A1-2014/153997
- CN-U- 202 120 961
- DE-U1- 202013 003 101
- GB-A- 2 586 003
- US-A1- 2006 007 549
- US-A1- 2012 097 212

## Beschreibung

Die Erfindung betrifft einen Solarzellenträger. Außerdem betrifft die Erfindung eine Photovoltaikvorrichtung mit mehreren solchen Solarzellenträgern. Darüber hinaus betrifft die Erfindung ein Verfahren zum Herstellen einer Photovoltaikvorrichtung und die Verwendung eines Solarzellenträgers in einer solchen Photovoltaikvorrichtung.

Aus dem Stand der Technik ist eine Vielzahl von unterschiedlich ausgebildeten Photovoltaikvorrichtungen bekannt, mittels denen Lichtenergie, insbesondere Sonnenenergie, in elektrische Energie umgewandelt wird. Die von der Photovoltaikvorrichtung bereitgestellte elektrische Energie kann an elektrische Verbraucher geliefert werden.

US 2012/0097212 A1 offenbart eine Photovoltaikvorrichtung, die an einem Hausdach angebracht wird. Die Photovoltaikvorrichtung weist einen länglichen mehrkantigen Hohlkörper auf, an dessen Innenseite Solarzellen angebracht sind. Darüber hinaus weist die Photovoltaikvorrichtung eine lichtdurchlässige Abdeckung auf, die an einem Ende des Hohlkörpers angebracht ist.

Die bekannte Photovoltaikvorrichtung weist den Nachteil auf, dass sie groß und/oder volumig ist und daher der Transport zu dem Anbringungsort, an dem die Photovoltaikvorrichtung beispielsweise an einem Hausdach angebracht wird, umständlich ist. Ein weiterer Nachteil der bekannten Photovoltaikvorrichtung besteht darin, dass sie einen geringen Wirkungsgrad aufweist.

Die Aufgabe der vorliegenden Erfindung besteht darin, eine Photovoltaikvorrichtung bereitzustellen, die einfach transportiert und zusammengebaut werden kann und die einen hohen Wirkungsgrad aufweist.

Die Aufgabe wird gelöst durch einen Solarzellenträger mit wenigstens einem Trägerelement, das wenigstens einen Schlitz aufweist, in den ein anderes Trägerelement eines anderen Solarzellenträgers anordenbar ist, wenigstens einer an einer Trägerelementseite angebrachten Solarzelle und wenigstens einem mit der wenigstens einen Solarzelle elektrisch verbundenen elektrischen Anschluss zum elektrischen Verbinden des Solarzellenträgers mit einem Abnehmer von elektrischer Energie.

Der erfindungsgemäße Solarzellenträger weist den Vorteil auf, dass die Photovoltaikvorrichtung einfach zusammengebaut werden kann. Außerdem sind gleiche Produktionsschritte möglich, um die Photovoltaikvorrichtung zusammenzubauen, wodurch eine kostengünstige Herstellung möglich ist. Dies ergibt sich, weil baugleiche Elementen, nämlich die Solarzellenträger, beim Zusammenbau der Photovoltaikvorrichtung eingesetzt werden.. Ein weiterer Vorteil des erfindungsgemäßen Solarzellenträgers besteht darin, dass er eine Vielzahl von Solarzellen aufweist. Wie nachfolgend noch näher beschrieben ist, ermöglicht dies, einen hohen Wirkungsgrad der Photovoltaikvorrichtung, wenn mehrere Solarzellenträger miteinander verbunden sind. Durch Verwenden der nachfolgend näher beschriebenen Solarzellenträger kann eine kompakte Photovoltaikvorrichtung bereitgestellt werden, die einfach zu transportieren ist.

Im Sinne der Erfindung wird als Solarzelle ein Bauteil verstanden, mittels dem Lichtenergie in elektrische Energie umgewandelt werden kann. Das Licht kann Sonnenlicht sein.

Bei einer besonderen Ausführung kann das Trägerelement lamellenartig ausgeführt sein. Insbesondere kann das Trägerelement rechteckförmig und/oder einstückig ausgebildet sein. Ein derartiges Trägerelement bietet den Vorteil, dass es eine Vielzahl von Solarzellen aufnehmen kann und beim Einbau in der Photovoltaikvorrichtung wenig Platz benötigt.

Das Trägerelement kann eine Trägerelementseite aufweisen, die mit einer reflektierenden Schicht versehen ist. Die reflektierende Schicht kann an der Trägerelementseite angebracht sein. An einer zur Trägerelementseite gegenüberliegenden Trägerelementseite kann ebenfalls eine reflektierende Schicht angebracht sein. Die reflektierende Schicht kann eine Spiegelfolie sein und/oder durch Aufdampfen auf das Trägerelement angebracht werden. Die beiden Trägerelementseiten können sich bezüglich einer Ebene, die eine Längsachse des Trägerelements enthält und zu beiden Seiten parallel verläuft, gegenüberliegen. Wie nachstehend näher erläutert ist, dient die reflektierende Schicht dazu, ein von der Solarzelle nicht absorbiertes Licht zu reflektieren. Das reflektierte Licht kann durch eine andere Solarzelle absorbiert werden. Im Ergebnis kann durch die reflektierende Schicht der Wirkungsgrad der Photovoltaikvorrichtung erhöht werden.

Der wenigstens eine elektrische Anschluss kann an einem Ende des Trägerelements angeordnet sein. Der elektrische Anschluss dient zum Abgeben der von der Solarzelle bereitgestellten elektrischen Energie an den nicht zum Solarzellenträger gehörenden Abnehmer. Insbesondere kann der Solarzellenträger zwei elektrische Anschlüsse, nämlich einen ersten elektrischen Anschluss und einen zweiten elektrischen Anschluss, aufweisen. Dabei kann der erste elektrischer Anschluss an einem ersten Ende des Trägerelements und der zweite elektrische Anschluss kann an einem zweiten Ende des Trägerelements angeordnet sein.

Das Trägerelement erstreckt sich entlang einer Längsrichtung und einer Höhenrichtung. Der elektrische Anschluss kann derart ausgebildet sein, dass er sich über die gesamte Höhe des Endes des Trägerelements erstreckt. Dadurch weist der elektrische Anschluss eine große Kontaktfläche auf, mittels der auf einfache Weise eine elektrische Verbindung mit dem Abnehmer realisiert werden kann, wenn der Solarzellenträger in einem nachfolgend näher beschriebenen Sockel der Photovoltaikvorrichtung eingesetzt wird. Bei einer alternativen Ausführung kann sich der elektrische Anschluss nicht entlang der gesamten Höhe des Endes des Trägerelements erstrecken. Das Trägerelement kann aus einem Polymer bestehen. So kann das Trägerelement aus Polymethylmethacrylat oder Polystyrol bestehen. Darüber hinaus kann das Trägerelement aus einem transparenten Material bestehen.

Bei einer besonderen Ausführung kann die Erstreckung des Schlitzes in Höhenrichtung des Solarzellenträgers zwischen 40 bis 60%, insbesondere 50%, der Höhe des Trägerelements betragen. Insbesondere bei einer Ausführung, bei der die Erstreckung des Schlitzes in Höhenrichtung 50 % der gesamten Höhe beträgt, wird auf einfache Weise erreicht, dass die miteinander verbundenen Solarzellenträger nicht voneinander abstehen. In anderen Worten, die Solarzellenträger sind, insbesondere in Höhenrichtung, bündig zueinander angeordnet. Durch eine derartige Schlitzausbildung wird somit sichergestellt, dass selbst bei verbundenen Solarzellenträgern eine räumlich kompakte Bauform realisiert wird.

Der Schlitz kann derart angeordnet sein, dass er sich von einem Ende des Trägerelements erstreckt. Das Trägerelement des anderen Solarzellenträgers kann über das zuvor genannte Schlitzende in den Schlitz eindringen. Im Ergebnis kann durch die Schlitzausbildung auf einfache Weise eine mechanische Verbindung zwischen dem Solarzellenträger und dem anderen Solarzellenträger erreicht werden. Dabei kann sich der Schlitz in Breitenrichtung entlang der gesamten Breite des Trägerelements erstrecken.

Das Trägerelement kann mehrere Schlitze aufweisen. Die einzelnen Schlitze können identisch zu dem zuvor beschriebenen Schlitz ausgebildet sein. Dabei können die Schlitze in Längsrichtung des Trägerelements beabstandet zueinander angeordnet sein. Die Schlitze können derart angeordnet sein, dass der Abstand zwischen zwei Schlitzen in Längsrichtung jeweils gleich ist.

Die Solarzelle kann in einem Trägerelementbereich angeordnet sein, der, insbesondere in Längsrichtung, durch zwei Schlitze begrenzt ist. Der Trägerelementbereich kann sich entlang der gesamten Höhe des Trägerelements erstrecken. Die Solarzellen können in Längsrichtung beabstandet zueinander angeordnet sein. Dabei kann die Erstreckung der Solarzelle im Trägerelementbereich in Längsrichtung 70-100%, vorzugsweise 90%, der Erstreckung des Trägerelementbereichs in Längsrichtung betragen.

Bei Ausführungen, bei denen der Solarzellenträger mehrere Solarzellen aufweist, existieren mehrere Trägerelementbereiche. Die einzelnen Trägerelementbereiche können sich in Längsrichtung des Trägerelements gleich weit erstrecken. Dies bedeutet, dass die Länge der einzelnen Trägerelementbereiche in Längsrichtung, also die Länge zwischen den jeweiligen Trägerelementbereich begrenzenden Schlitzen, jeweils gleich ist. Die einzelnen Trägerelementbereiche können in Längsrichtung versetzt zueinander angeordnet sein.

Ein Endbereich des Trägerelements kann den elektrischen Anschluss aufweisen. Dabei kann ein erster Endbereich des Trägerelements den ersten elektrischen Anschluss und ein zweiter Endbereich des Trägerelements den zweiten elektrischen Anschluss aufweisen. Der Endbereich wird in Längsrichtung durch eine Stirnseite des Trägerelements und einen Schlitz begrenzt. Dabei kann der Abstand zwischen der Stirnseite und dem Schlitz im Endbereich kleiner sein als der Abstand zwischen zwei Schlitzen im Trägerelementbereich.

Der Solarzellenträger kann eine andere Solarzelle aufweisen, die an einer der Trägerelementseite gegenüberliegenden Trägerelementseite angeordnet ist. Somit weist der Solarzellenträger an seinen beiden Trägerelementseiten Solarzellen auf, wodurch sich die photovoltaisch nutzbare Fläche des Solarzellenträgers, die zur Umwandlung von Sonnenenergie in elektrische Energie dient, erhöht. Die andere Solarzelle kann identisch zu der Solarzelle ausgebildet sein.

Bei einer besonderen Ausführung kann der Solarzellenträger mehrere Trägerelemente aufweisen. Die einzelnen Trägerelemente können analog zu dem oben beschriebenen Trägerelement ausgebildet sein. Insbesondere kann jedes Trägerelement wenigstens eine Solarzelle aufweisen, die an einer Trägerelementseite anliegt.

Dabei kann das Trägerelement mit einem anderem Trägerelement fest verbunden sein. Die feste Verbindung kann eine stoffschlüssige Verbindung sein. Eine Trägerelementseite kann an einer anderen Trägerelementseite anliegen, sodass vorteilhafter Weise die beiden Trägerelementseiten direkt miteinander verbunden werden können. Dabei werden nur die Trägerelementseiten aneinanderliegen, an denen keine Solarzelle angebracht ist. Das Trägerelement und das andere Trägerelement können derart miteinander verbunden sein, dass der Schlitz des Trägerelements zu dem anderen Schlitz des anderen Trägerelements fluchtet. Durch die fluchtende Anordnung der beiden Schlitze ist sichergestellt, dass der Solarzellenträger mit dem anderen Solarzellenträger verbunden werden kann.

Die Solarzelle kann eine organische Solarzelle sein. Dabei kann die Solarzelle eine transparente oder semitransparente Solarzelle sein und/oder einen gestapelten Aufbau aufweisen. Die semitransparente Solarzelle kann zumindest einen Teil des Lichts durchlassen. Die Erstreckung der Solarzelle in Höhenrichtung kann zwischen 70-100%, vorzugsweise 95%, der Höhe des Trägerelements betragen. Durch eine derart ausgebildete Solarzelle wird eine große photovoltaisch nutzbare Fläche bereitgestellt.

Der Solarzellenträger kann eine Schutzschicht aufweisen, die auf der Solarzelle und/oder der Trägerelementseite und/oder der Trägerelementseite gegenüberliegenden Trägerelementseite angebracht ist. Durch die Schutzschicht wird das Risiko einer Beschädigung der Solarzelle beispielsweise beim Zusammenbau der Photovoltaikvorrichtung reduziert.

Von besonderem Vorteil ist eine Photovoltaikvorrichtung mit mehreren erfindungsgemäßen Solarzellenträgern, nämlich mit ersten Solarzellenträgern und mit zweiten Solarzellenträgern, die miteinander verbunden sind. Die Photovoltaikvorrichtung kann mehrere erste Solarzellenträger und mehrere zweite Solarzellenträger aufweisen. Die ersten und zweiten Solarzellenträger können, wie oben beschrieben ist, ausgebildet sein. Insbesondere können die ersten und zweiten Solarzellenträger gleich ausgebildet sein.

Dabei kann ein Solarzellenträger derart ausgebildet sein, dass er mit mehreren anderen Solarzellenträgern, insbesondere mechanisch, verbunden ist. Dabei kann in jedem Schlitz eines Solarzellenträgers ein anderer Solarzellenträger angeordnet sein. Somit kann die Anzahl der Schlitze des Solarzellenträgers der mit dem Solarzellenträger zu verbindenden anderen Solarzellenträgern entsprechen. Die Solarzellenträger können zum gegenseitigen Verbinden formschlüssig ineinandergreifen. Die Formschlussverbindung kann durch Einbringen des anderen Solarzellenträgers in den Schlitz des Solarzellenträgers erfolgen.

Besonders vorteilhaft ist eine Ausführung, bei der an wenigstens einer Überkreuzungsstelle von jeweils zwei Solarzellenträgern jeder der Solarzellenträger derart angeordnet ist, dass der Schlitz des jeweiligen Solarzellenträgers mit seinem offenen Ende in Richtung zum anderen Solarzellenträger weist. Bei der Überkreuzungsstelle kann jeder der beiden Solarzellenträger in den Schlitz des jeweils anderen Solarzellenträgers eingesteckt sein. Das Einstecken erfolgt derart, dass die beiden Solarzellenträger gegenseitig formschlüssig ineinandergreifen.

Die Solarzellenträger können kreuzweise miteinander verbunden werden. Insbesondere können die Solarzellenträger in ihren Überkreuzungsstellen rechtwinklig überkreuzt angeordnet sein. Dadurch können Solarzellenträger in einem verbundenen Zustand eine Gitterstruktur bilden. Die Gitterstruktur kann dann erreicht werden, wenn mehrere erste Solarzellenträger mit mehreren zweiten Solarzellenträgern, insbesondere mechanisch, verbunden werden. Dabei sind die mehreren ersten Solarzellenträger parallel zueinander angeordnet. Außerdem sind die mehreren zweiten Solarzellenträger parallel zueinander angeordnet.

Die miteinander verbundenen Solarzellenträger können in Höhenrichtung eines Solarzellenträgers bündig zueinander angeordnet sind. Dies ist aufgrund der oben beschriebenen Schlitzausbildung der jeweiligen Solarzellenträger möglich.

Bei einer besonderen Ausführung können mehrere, insbesondere wenigstens drei, vorzugsweise genau vier, Solarzellenträger einen Hohlraum begrenzen. Insbesondere können zwei erste Solarzellenträger und zwei zweite Solarzellenträger den Hohlraum begrenzen. Die beiden ersten Solarzellenträger sind parallel zueinander angeordnet und die beiden zweiten Solarzellenträger sind parallel zueinander angeordnet. Dabei ist jedes der beiden zweiten Solarzellenträger, insbesondere kreuzweise, mit den beiden ersten Solarzellenträgern verbunden. Im Ergebnis wird auf einfache Weise ein, insbesondere im Querschnitt quadratischer, Hohlraum erzeugt, der durch die Solarzellenträger begrenzt ist. Dabei bilden die Solarzellenträger einen Hohllichtleiter, der den Hohlraum aufweist.

Der Hohlraum weist an einem Ende eine Öffnung auf, durch die Licht in den Hohlraum einbringbar ist. Eine Öffnungsfläche der Öffnung kann kleiner sein als eine den Hohlraum umschließende Mantelfläche. Der Hohlraum wird durch die Trägerelementbereiche der Solarzellenträger begrenzt. Insofern entspricht die Mantelfläche der Fläche der Trägerelementbereiche. Darüber hinaus kann die Öffnungsfläche kleiner sein als eine photovoltaische nutzbare Fläche. Die photovoltaische nutzbare Fläche ist kleiner als die Mantelfläche und/oder hängt von der Ausbildung und/oder Anzahl der Solarzellen ab, die mit dem in den Hohlraum eingebrachten Licht beaufschlagt werden können.

Der zuvor beschriebene Hohllichtleiter weist den Vorteil auf, dass durch Vorsehen der sich über nahezu die gesamte Höhe des Hohlraums erstreckenden Solarzellen der Wirkungsgrad erhöht werden kann. Insbesondere das Vorsehen der reflektierenden Schicht auf dem Trägermaterial ermöglicht, dass der durch die vorzugsweise semi-transparente organische Solarzelle nicht absorbierte Lichtstrahl reflektiert und somit im Hohlraum gehalten wird. Dies bedeutet, dass das nicht absorbierte Licht durch eine andere Solarzelle absorbiert werden kann. Dadurch erhöht sich der Wirkungsgrad der Photovoltaikvorrichtung ebenfalls.

Bei einer besonderen Ausführung kann die Photovoltaikvorrichtung einen, insbesondere quaderförmigen, Sockel zum Halten der, insbesondere miteinander verbundenen, Solarzellenträger aufweisen. Der Sockel kann aus Kunststoff bestehen und/oder einen Sockelboden aufweisen, der den Hohlraum begrenzt. Insbesondere kann der Sockelboden ein der Öffnung gegenüberliegendes Ende des Hohlraums zu begrenzen. Der Sockelboden kann eine reflektierende Schicht aufweisen oder ein Reflektor sein. Dadurch wird auf einfache Weise sichergestellt, dass das in den Hohlraum eingebrachte Licht wieder reflektiert wird und somit von einer Solarzelle absorbiert werden kann. Dabei kann das Licht über die oben genannte Öffnung aus dem Hohlraum austreten. An dem Sockelboden können Solarzellen angebracht sein, um den Sockelboden photovoltaisch nutzbar zu machen. Im Ergebnis erhöht sich dadurch der Wirkungsgrad der Photovoltaikvorrichtung.

Der Sockel kann außerdem eine Sockelwand aufweisen und mehrere Aussparungen zum Aufnehmen des Solarzellenträgers aufweisen, die in der Sockelwand angeordnet sind. Alle Aussparungen sind identisch ausgebildet. Die einzelnen Aussparungen können entlang der Sockelwand beabstandet zueinander angeordnet sein. Der Sockel kann spiegelsymmetrisch ausgebildet sein. Die Aussparung kann sich über die komplette Höhe des Sockels erstrecken.

Beim Einbringen des Solarzellenträgers in den Sockel kann der Endabschnitt des Solarzellenträgers in die Aussparung eindringen. Die Aussparung kann formkomplementär zu dem Endabschnitt ausgebildet sein, sodass eine sichere Verbindung zwischen dem Solarzellenträger und dem Sockel erzielt wird. Darüber hinaus kann die Aussparung zum Aufnehmen eines Halteabschnitts einer weiter unten beschriebenen Lichtverteileinrichtung dienen.

Im verbundenen Zustand des Solarzellenträgers mit dem Sockel kann der elektrische Abschnitt des Solarzellenträgers in der Aussparung angeordnet sein. Die Aussparung kann eine elektrische Leitung, insbesondere eine Vertikalleitung, des Abnehmers aufweisen, sodass im verbundenen Zustand des Solarzellenträgers mit dem Sockel eine elektrische Verbindung zwischen dem Solarzellenträger und dem Abnehmer der elektrischen Energie besteht.

In sich gegenüberliegenden Seiten können die Aussparungen derart angeordnet sein, dass der erste elektrische Abschnitt des Solarzellenträgers in einer ersten Aussparung und der zweite elektrische Abschnitt in einer zweiten Aussparung angeordnet ist.

Der Sockel weist den Vorteil auf, dass er eine Vielzahl von Solarzellenträgern aufnehmen kann. Dementsprechend kann eine Vielzahl von Hohlräumen durch die verbundenen Solarzellenträger begrenzt werden, in die Licht eingebracht werden kann. Somit erhöht sich der Wirkungsgrad der Photovoltaikvorrichtung.

Wie oben bereits beschrieben ist, weist die Photovoltaikvorrichtung einen Abnehmer für elektrische Energie auf, der mit einem elektrischen Verbraucher elektrischer verbindbar ist. Der Abnehmer dient zum Abführen der von den Solarzellen bereitgestellten elektrischen Energie an den elektrischen Verbraucher. So kann der Abnehmer wenigstens eine Bodenleitung und wenigstens eine Vertikalleitung aufweist, die mit der Bodenleitung elektrisch verbunden ist und sich von der Bodenleitung erstreckt. Der Abnehmer, insbesondere die wenigstens eine Vertikalleitung, kann in die Aussparung oder Aussparungen des Sockels eingebracht werden.

Der Abnehmer kann eine erste Bodenleitung aufweisen, von der sich eine erste Vertikalleitung oder mehrere erste Vertikalleitungen erstrecken. Darüber hinaus kann der Abnehmer eine zweite Bodenleitung aufweisen, von der sich eine zweite Vertikalleitung oder mehrere zweite Vertikalleitungen erstrecken. Der erste elektrische Abschnitt des Solarzellenträgers kann mit der ersten Vertikalleitung elektrisch verbunden sein. Der zweite elektrische Abschnitt des Solarzellenträgers kann mit der zweiten elektrischen Leitung elektrisch verbunden sein. Somit fungiert die erste Bodenleitung zusammen mit der ersten Vertikalleitung als Anode und die zweite Bodenleitung zusammen mit den zweiten Vertikalleitungen als Kathode. Die beiden Bodenleitungen können mit dem elektrischen Verbraucher elektrisch verbunden sein.

Bei einer besonderen Ausführung kann die Photovoltaikvorrichtung eine Lichtverteileinrichtung aufweisen. Die Lichtverteileinrichtung kann, insbesondere direkt, auf die Solarzellenträger gesetzt werden. Dabei kann die Lichtverteileinrichtung in einen Innenraum des Sockels eingesetzt werden. Die Lichtverteileinrichtung und der Sockel können derart ausgebildet sein, dass eine Oberseite der Lichtverteileinrichtung bündig zu einer Oberseite des Sockels ist, wenn die Lichtverteileinrichtung in den Innenraum des Sockels eingesetzt ist. Dadurch wird eine kompakte Photovoltaikvorrichtung realisiert.

Die Lichtverteileinrichtung kann wenigstens eine Linse oder mehrere Linsen, insbesondere Konkavlinsen, vorzugsweise Bi-Konkavlinsen aufweisen. Die Linse kann sphärisch, dachkantenprismaförmig, pyramidenförmig oder in einer anderen geometrischen Ausführung ausgebildet sein. Dabei kann die Lichtverteileinrichtung eine Sammellinse zum Sammeln von Licht und/oder eine Streulinse zum Streuen von Licht aufweisen. Die Sammellinse und die Streulinse können derart angeordnet sein, dass die Sammellinse Licht sammelt und die Streulinse das durch die Sammellinse gesammelte Licht, insbesondere in den Hohlraum streut. Das Licht kann Sonnenlicht sein.

Die Lichtverteileinrichtung kann eine Linsenhalterung zum Halten wenigstens einer Streulinse und/oder wenigstens einer Sammellinse aufweisen. Dabei kann die Anzahl der Streulinsen und/oder Sammellinsen der Anzahl an Hohlräumen entsprechen, die durch die Solarzellenträger begrenzt werden. Dadurch wird auf einfache Weise sichergestellt, dass jedem Hohlraum eine Streulinse und/oder Sammellinse zugewiesen ist. Die Linsenhalterung kann aus einem transparenten Material bestehen. Insbesondere kann die Linsenhalterung aus Glas oder Polymethylmethacrylat bestehen.

Die Linsenhalterung kann wenigstens einen Halteabschnitt aufweisen, der in der Aussparung des Sockels angeordnet ist, insbesondere wenn die Linsenverteileinrichtung in den Innenraum des Sockels eingebracht ist. Dabei kann die Anzahl der Halteabschnitte der Anzahl der Aussparungen des Sockels entsprechen. Die Linsenhalterung kann eine, insbesondere transparente, Polymerplatte sein und/oder als Deckel der Photovoltaikvorrichtung fungieren, die die Solarzellenträger, insbesondere vollständig abdeckt.

Der Sockelboden, die Solarzellenträger und die Linsenverteileinrichtung schließen den oben genannten Hohlraum vollständig ein. In den Hohlraum kann beim Herstellen der Photovoltaikvorrichtung die Luft durch ein anderes Gas, insbesondere Stickstoff, ersetzt werden. Besonders vorteilhaft ist, wenn das Gas einen geringeren Lichtwiderstand als Luft aufweist.

Gemäß einem anderen Aspekt der Erfindung ist ein Verfahren zum Herstellen einer erfindungsgemäßen Photovoltaikvorrichtung vorgesehen. Das Verfahren ist dadurch gekennzeichnet, dass
wenigstens ein erster Solarzellenträger in einen Innenraum eines Sockels der Photovoltaikvorrichtung eingesetzt wird und
wenigstens ein zweiter Solarzellenträger mit dem ersten Solarzellenträger verbunden wird.

Dabei kann der erste Solarzellenträger derart in den Sockel eingesetzt werden, dass ein offenes Ende des Schlitzes an einem vom Sockelboden abgewandten Ende angeordnet ist. Der zweite Solarzellenträger kann derart in den Sockel eingesetzt werden, dass ein offenes Ende des Schlitzes in Richtung zu dem ersten Solarzellenträger weist. Der erste Solarzellenträger kann mit dem zweiten Solarzellenträger dadurch verbunden werden, dass der zweite Solarzellenträger in den ersten Solarzellenträger, insbesondere in den Schlitz des ersten Solarzellenträger, eingesteckt wird. Im Ergebnis können die Solarzellenträger durch Steckverbinden miteinander, insbesondere mechanisch, verbunden werden. Dadurch kann die Photovoltaikvorrichtung auf einfache Weise hergestellt werden.

Der zweite Solarzellenträger kann gleichzeitig mit einer Vielzahl von ersten Solarzellenträgern verbunden wird. Dies ist möglich, wenn zuvor die Vielzahl der ersten Solarzellenträger in den Innenraum des Sockels eingesetzt wurden. Die ersten Solarzellenträger können parallel zueinander in dem Innenraum des Sockels angeordnet werden. Dies ist durch die oben beschriebene Lage und Ausbildung der Aussparungen in der Sockelwand möglich.

Der Abnehmer von elektrischer Energie, insbesondere die Vertikalleitungen, kann in die wenigstens eine Aussparung des Sockels eingebracht werden, bevor der erste und/oder zweite Solarzellenträger in den Innenraum des Sockels eingesetzt wird. Die Lichtverteileinrichtung kann in den Innenraum des Sockels eingebracht werden, nachdem die Solarzellenträger miteinander verbunden werden.

Gemäß einem anderen Aspekt der Erfindung wird ein erfindungsgemäßer Solarzellenträger in einer Photovoltaikvorrichtung verwendet.

In den Figuren ist der Erfindungsgegenstand schematisch dargestellt, wobei gleiche oder gleichwirkende Elemente zumeist mit denselben Bezugszeichen versehen sind. Dabei zeigt:
- Fig. 1: eine perspektivische Darstellung eines ersten Solarzellenträgers gemäß einer Ausführungsform der Erfindung,
- Fig. 2: eine Seitenansicht des in Figur 1 gezeigten Solarzellenträgers,
- Fig. 3: eine perspektivische Darstellung eines zweiten Solarzellenträgers gemäß einer Ausführungsform der Erfindung,
- Fig. 4: eine Seitenansicht des in Figur 2 gezeigten Solarzellenträgers,
- Fig. 5A bis 5C: eine Draufsicht auf drei unterschiedliche Ausführungsformen eines Solarzellenträgers,
- Fig. 6: eine Schnittansicht durch einen Teil eines Solarzellenträgers gemäß einer Ausführungsform der Erfindung,
- Fig. 7: eine Draufsicht auf einen Sockel einer Photovoltaikvorrichtung gemäß einer Ausführungsform der Erfindung,
- Fig. 8: eine perspektivische Darstellung eines Abnehmers für elektrische Energie,
- Fig. 9: eine perspektivische Darstellung einer Photovoltaikvorrichtung mit eingebauten Solarzellenträgern,
- Fig. 10: eine Draufsicht auf die in Fig. 9 gezeigte Photovoltaikvorrichtung,
- Fig.11: eine Schnittansicht entlang der Linie A-A aus Fig. 10,
- Fig. 12: eine vergrößerte Darstellung eines durch Solarzellenträger begrenzten Hohlraums,
- Fig. 13: einen Lichtstrahlverlauf durch einen Teil des Hohlraums,
- Fig. 14: einen Lichtstrahlverlauf durch den Hohlraum,
- Fig. 15: eine Draufsicht auf eine Lichtverteileinrichtung,
- Fig. 16: eine Draufsicht auf die Photovoltaikvorrichtung mit eingebauter Lichtverteileinrichtung,
- Fig. 17: eine Seitenschnittansicht entlang einer Linie B-B aus Fig. 16,
- Fig. 18: eine perspektivische Darstellung der Photovoltaikvorrichtung mit eingebauter Lichtverteileinrichtung gemäß einer weiteren Ausführung.

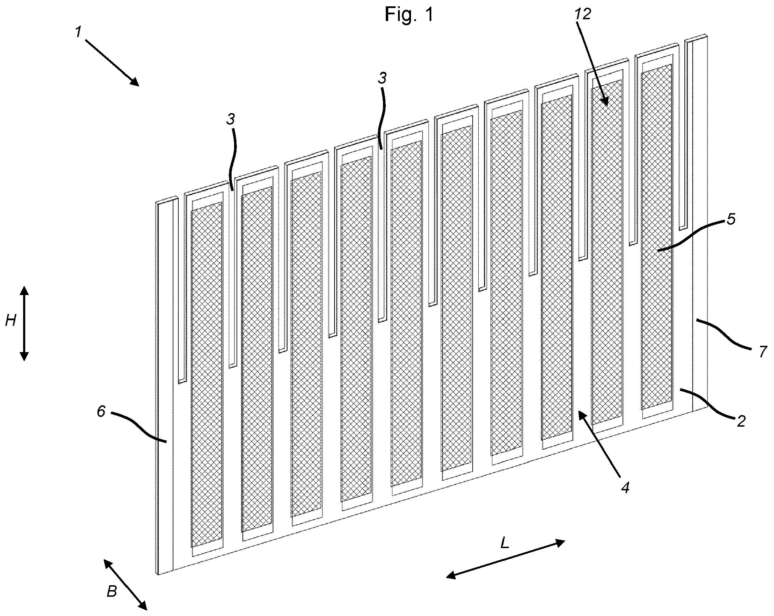

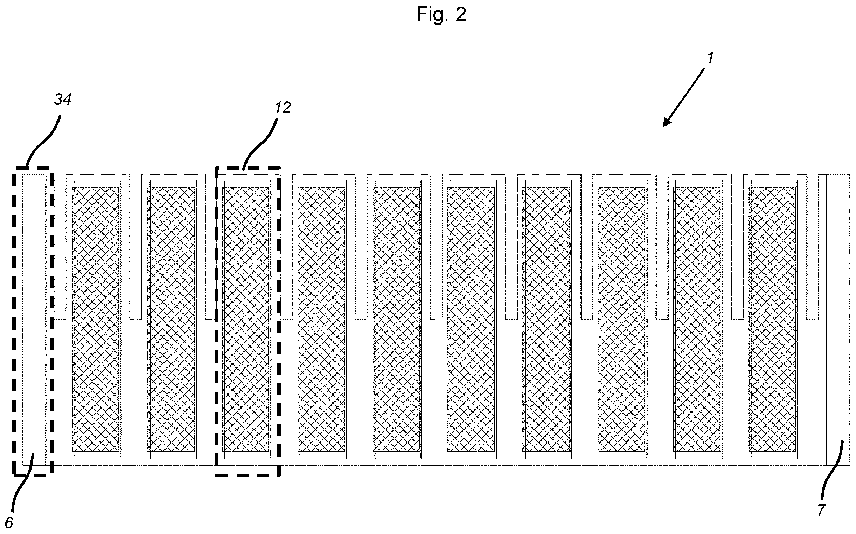

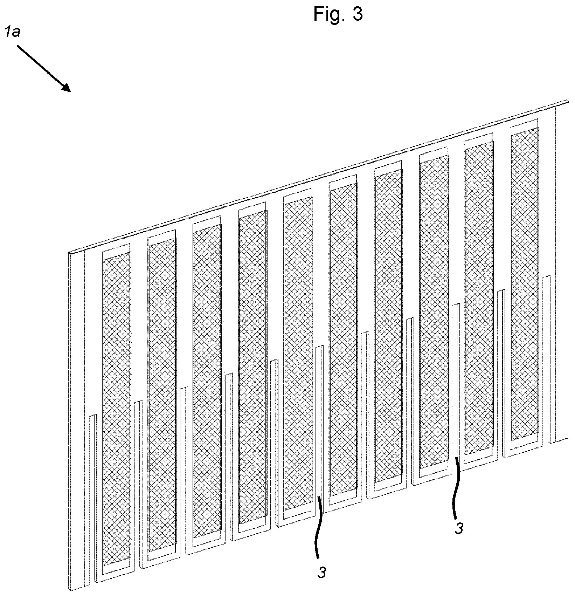

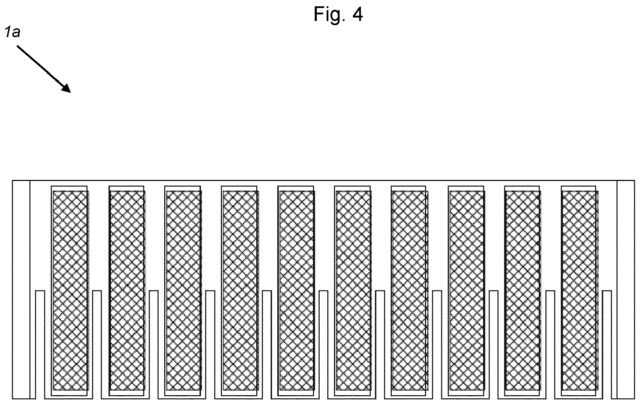

Figur 1 und 2 zeigen jeweils einen Solarzellenträger, der im Folgenden als erster Solarzellenträger 1 bezeichnet ist. Der erste Solarzellenträger 1 weist ein Trägerelement 2 auf, das mehrere Schlitze 3 aufweist. An einer Trägerelementseite 4 sind mehrere Solarzellen 5 angebracht. Die Solarzellen 5 sind entlang einer Längsrichtung L des ersten Solarzellenträgers 1 beabstandet zueinander angeordnet und/oder können organische Solarzellen sein. Der erste Solarzellenträger 1 weist außerdem einen ersten elektrischen Anschluss 6, der an einem ersten Ende des ersten Solarzellenträgers 1 angeordnet ist, und einen zweiten elektrischen Anschluss 7 auf, der an einem zweiten Ende des ersten Solarzellenträgers 1 angeordnet ist. In jeden der Schlitze 3 kann jeweils ein in den Figuren 3 und 4 gezeigter zweiter Solarzellenträger 1a angeordnet werden. Insbesondere kann in die jeweiligen Schlitze 3 jeweils ein zweiter Solarzellenträger 1a eingesteckt werden.

Der erste Solarzellenträger 1 ist lamellenartig und rechteckförmig ausgeführt. Aufgrund der lamellenartigen Ausführung erstreckt sich der erste Solarzellenträger 1 in Längsrichtung L länger als in Breitenrichtung B. Außerdem ist die Erstreckung des ersten Solarzellenträgers 1 in Längsrichtung L und Höhenrichtung H größer als in Breitenrichtung B.

Alle Schlitze 3 sind identisch ausgeführt, sodass im Folgenden nur ein Schlitz 3 beschrieben ist. Der Schlitz 3 weist ein offenes Ende auf. Darüber hinaus weist der Schlitz 3 eine Länge auf, die zwischen 40-60%, insbesondere 50%, der Höhe des Trägerelements 2 beträgt. Dagegen erstreckt sich der Schlitz 3 entlang der gesamten Breite des Trägerelements 2.

Das Trägerelement 2 weist mehrere Trägerelementbereiche 12 auf, deren Erstreckung entlang der Längsrichtung L jeweils durch zwei Schlitze 3 begrenzt ist. Die einzelnen Trägerelementbereiche 12 erstrecken sich in Längsrichtung L jeweils gleich weit. Die Trägerelementbereiche 12 erstrecken sich entlang der gesamten Höhe des Trägerelements 2. An jedem der Trägerelementabschnitte 5 ist jeweils eine Solarzelle 5 angebracht. Die Solarzelle 5 weist eine Länge auf, die zwischen 70-100%, insbesondere 95%, der gesamten Höhe des Trägerelements 2 beträgt. Die Solarzellen 5 weisen jeweils einen rechteckförmigen Verlauf auf.

Das Trägerelement 2 weist außerdem zwei Endbereiche 34 auf, die jeweils einen elektrischen Anschluss 6, 7 enthalten. Beide Endbereiche werden durch eine Stirnseite des Trägerelements 2 und den der Stirnseite am nächsten angeordnete Schlitz 3 begrenzt. Die Erstreckung des Endabschnitts 34 in Längsrichtung L ist geringer als beim Trägerelementabschnitt 5. Die beiden elektrischen Abschnitte 6, 7 bestehen jeweils aus einem elektrisch leitfähigen Material. Beide elektrische Abschnitte 6, 7 erstrecken sich über die gesamte Höhe des Trägerelements 2.

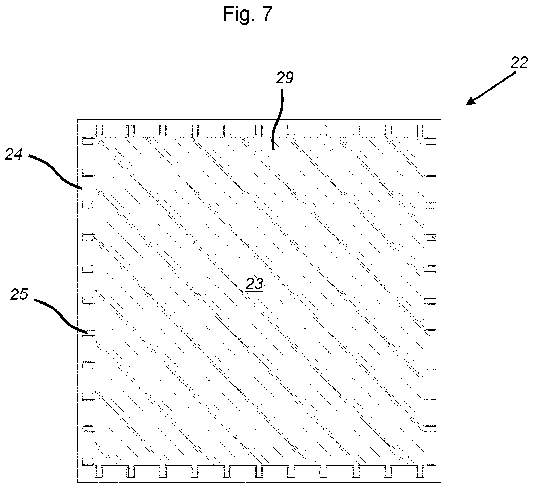

Figuren 3 und 4 zeigen ebenfalls einen Solarzellenträger, der im Folgenden als zweiter Solarzellenträger 1a bezeichnet wird. Der zweite Solarzellenträger 1a ist identisch wie der erste Solarzellenträger 1a aufgebaut. Der Unterschied zwischen den beiden Solarzellenträgern 1, 1a besteht darin, wie sie in einen in Figur 7 dargestellten Sockel 22 eingebaut werden.

So wird der erste Solarzellenträger 1 in der in Figur 2 dargestellten Stellung in den Sockel 22 eingesetzt, sodass das offene Schlitzende nach oben weist. Die zweiten Solarzellenträger 1a werden anschließend mit den ersten Solarzellenträgern 1 mechanisch verbunden. Dazu wird der zweite Solarzellenträger 1a derart positioniert, dass das offene Schlitzende, wie aus Figur 4 ersichtlich ist, nach unten weist. Der zweite Solarzellenträger 1a wird entlang der Höhenrichtung H abgesenkt, sodass das Trägerelement 2 des jeweiligen Trägerelements 2 in den Schlitz 3 des jeweils anderen Trägerelements 2 eindringt. Im Ergebnis wird eine formschlüssige Verbindung zwischen den beiden Solarzellenträgern 1, 1a realisiert.

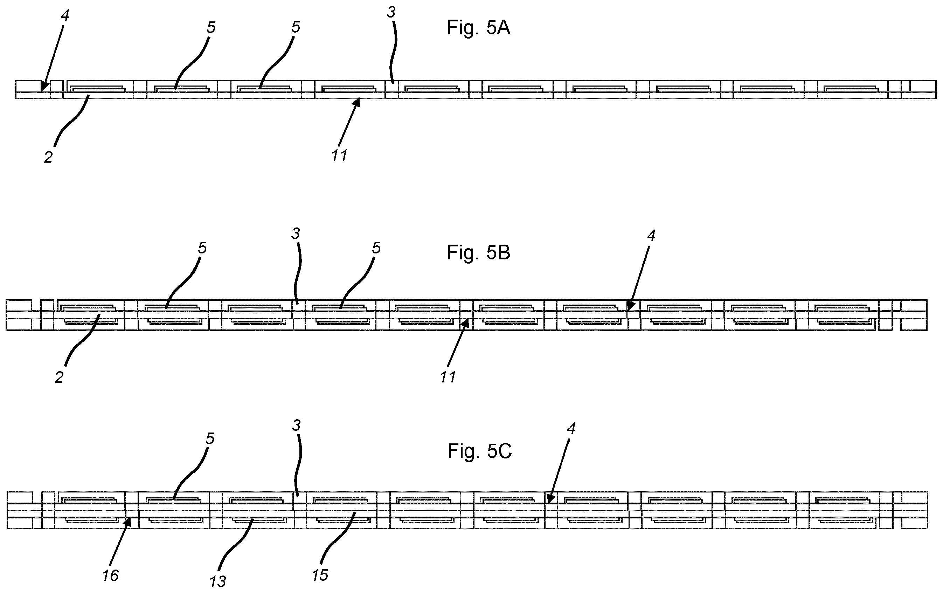

Die Figuren 5A bis 5C zeigen drei unterschiedliche Ausbildungen eines Solarzellenträgers. Wie zuvor erläutert ist, unterscheidet sich der erste Solarzellenträger 1 nicht von dem zweiten Solarzellenträger 1a, sodass das Nachfolgende sowohl für den ersten Solarzellenträger 1 als auch für den zweiten Solarzellenträger 1a gilt.

Bei der in Figur 5A dargestellten Ausführung sind die Solarzellen 5 lediglich an der Trägerelementseite 4 angeordnet. Dies bedeutet, dass an einer der Trägerelementseite 4 gegenüberliegenden Trägerelementseite 11 keine Solarzellen angeordnet sind.

Die in Figur 5B dargestellte Ausführung unterscheidet sich von der in Figur 5A dargestellten Ausführung darin, dass sowohl an der Trägerelementseite 4 als auch an der der Trägerelementseite 4 gegenüberliegenden Trägerelementseite 11 Solarzellen 5 angeordnet sind.

Die in Figur 5C dargestellte Ausführung unterscheidet sich von der in Figur 5A dargestellten Ausführung darin, dass zusätzlich zu dem Trägerelement 2 ein anderes Trägerelement 15 vorhanden ist. An dem anderen Trägerelement 15 sind an einer anderen Trägerelementseite 16 andere Solarzellen 13 angeordnet. Die beiden Trägerelemente 2, 15 sind fest miteinander verbunden und liegen an ihren Trägerelementseiten an, an denen keinen Solarzellen 5, 13 angebracht sind. Die beiden Trägerelemente 2, 15 sind derart zueinander positioniert, dass die Schlitze 3 fluchten. Ein derartig ausgebildeter Solarzellenträger kann in Breitenrichtung doppelt so groß sein wie der in Figur 5A dargestellte Solarzellenträger.

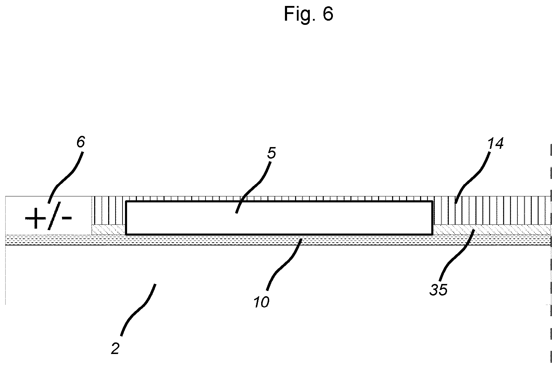

Fig. 6 zeigt eine Schnittansicht durch einen Teil eines in den Figuren 1 bis 4 gezeigten Solarzellenträgers 1, 1a. Aus Fig. 6 ist ersichtlich, dass an das Trägerelement 2 eine reflektierende Schicht 10 aufgebracht ist. Die reflektierende Schicht 10 wird über die gesamte Länge und Höhe des Trägerelements 2 aufgebracht. Die Solarzelle 5 ist auf die reflektierende Schicht 10 aufgebracht. Darüber hinaus ist eine elektrisch leitfähige Schicht 35 auf die reflektierende Schicht 10 aufgebracht.

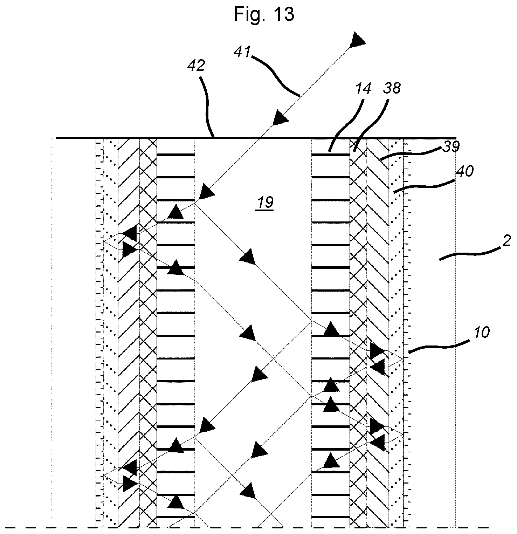

Die Solarzelle 5 ist eine organische Solarzelle, deren Aufbau in Fig. 13 detaillierter dargestellt ist. Die Solarzelle 5 ist mit der elektrisch leitfähigen Schicht 35 elektrisch verbunden. Der in Figur 6 außerhalb der Solarzelle 5 angeordnete Teil der elektrisch leitfähigen Schicht 35 verbindet die Solarzelle 5 mit den beiden elektrischen Anschlüssen 6, 7, wobei in Figur 6 nur der erste elektrische Anschluss 6 dargestellt ist. Der Solarzellenträger 1, 1a weist außerdem eine Schutzschicht 14 auf. Die Schutzschicht 14 ist, insbesondere direkt auf die organische Solarzelle 5 und die elektrisch leitfähige Schicht 35 aufgebracht. Die organische Solarzelle kann in dargestellten Ausführungen einen anderen Aufbau als in Figur 13 aufweisen.

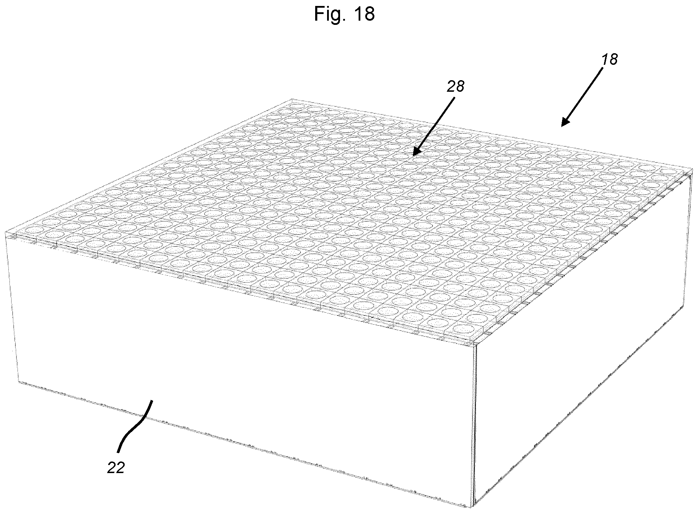

Fig. 7 zeigt eine Draufsicht auf einen Sockel 22 einer in Fig. 18 gezeigten Photovoltaikvorrichtung 18. Der Sockel 22 ist quaderförmig ausgebildet und weist einen Sockelboden 23 auf. Darüber hinaus weist der Sockel 22 Sockelwände 24 auf, die einen Innenraum 29 des Sockels 22 begrenzen. Der Innenraum 29 ist durch die Sockelwände 24 in tangentialer Richtung des Sockels 22 und durch den Sockelboden 23 in Axialrichtung des Sockels 22 begrenzt.

Der Sockel 22 weist eine Vielzahl von Aussparungen 25 in den Seitenwänden 24 auf. Die Aussparrungen 25 sind entlang der Erstreckungsrichtung der Seitenwand 24 beabstandet zueinander angeordnet. Die Aussparungen liegen sich aufgrund der spiegelsymmetrischen Ausbildung des Sockels 22, insbesondere bezüglich einer Spiegelebene, gegenüber.

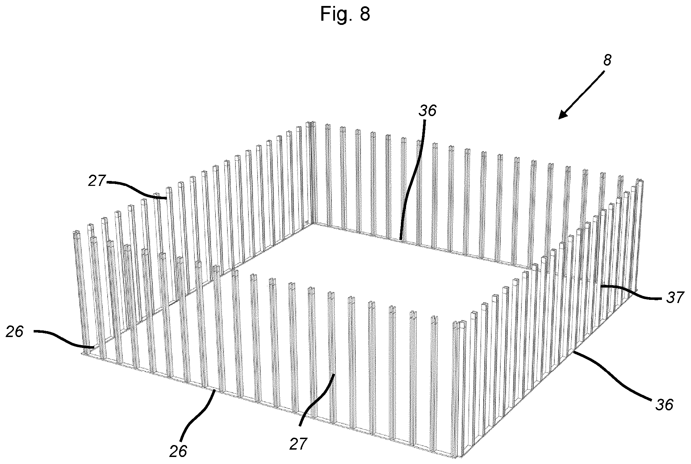

Fig. 8 zeigt eine perspektivische Darstellung eines Abnehmers 8 für elektrische Energie. Der Abnehmer 8 besteht aus zwei Komponenten. Eine erste Komponente weist eine erste Bodenleitung 26 und eine Vielzahl sich von der ersten Bodenleitung 26 erstreckenden Vertikalleitungen 27 auf. Eine zweite Komponente weist eine zweite Bodenleitung 36 und eine Vielzahl sich von der zweiten Bodenleitung 36 erstreckenden Vertikalleitungen 37 auf.

Die erste Bodenleitung 26 und die zweite Bodenleitung 36 sind jeweils mit einem in den Figuren nicht dargestellten elektrischen Verbraucher elektrisch verbunden. Im Zusammengebauten Zustand ist der Abnehmer 8 in den Sockel 22 eingebracht. Insbesondere ist jeweils eine Vertikalleitung 27, 37 in einer Aussparung 25 des Sockels 22 angeordnet.

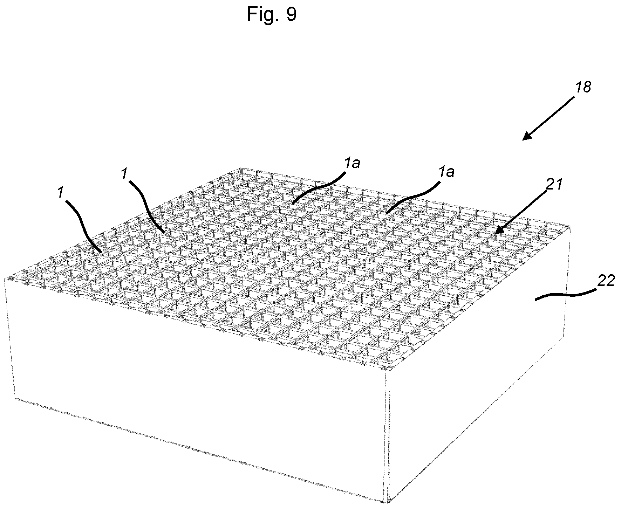

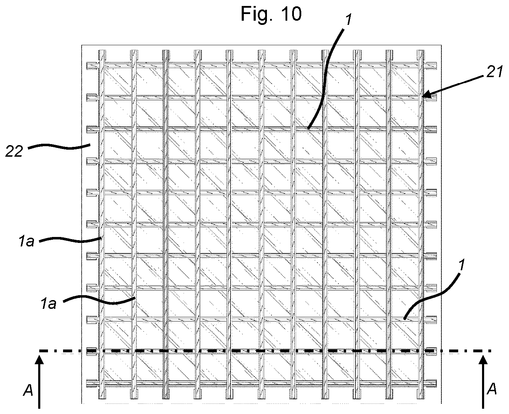

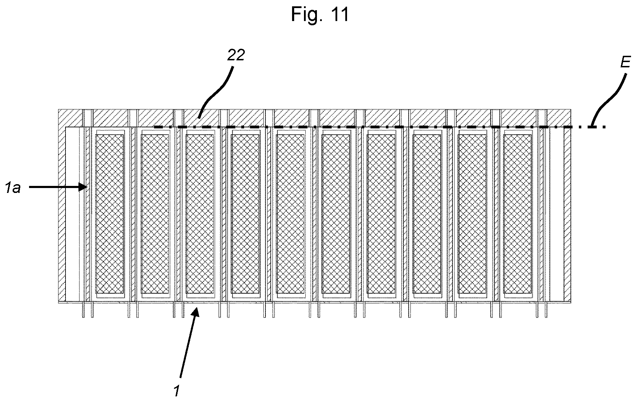

Fig. 9 zeigt eine perspektivische Darstellung der Photovoltaikvorrichtung 18 mit eingebauten Solarzellenträger 1, 1a und Fig. 10 zeigt eine Draufsicht auf die in Fig. 9 gezeigte Photovoltaikvorrichtung 18. Die Solarzellenträger 1, 1a sind in den Innentraum 23 des Sockels 22 eingesetzt. Fig.11 zeigt eine Schnittansicht entlang der Linie A-A aus Fig. 10,

Die Photovoltaikvorrichtung 18 weist eine Vielzahl von ersten Solarzellenträgern 1 und eine Vielzahl von zweiten Solarzellenträgern 1a auf. Die ersten Solarzellenträger 1 sind parallel zueinander angeordnet. Darüber hinaus sind die zweiten Solarzellenträger 1a parallel zueinander angeordnet. Die Solarzellenträger 1, 1a sind kreuzweise miteinander verbunden und bilden somit eine Gitterstruktur. Dabei sind die Solarzellenträger 1, 1a in ihren Überkreuzungsstellen 21 jeweils rechtwinklig überkreuzt angeordnet.

Dabei ist ein erster Solarzellenträger 1 mit einer Vielzahl von zweiten Solarzellenträgern 1a verbunden. Gleichermaßen ist ein zweiter Solarzellenträger 1a mit einer Vielzahl von ersten Solarzellenträgern 1 verbunden. Aufgrund der oben beschriebenen Ausbildung der Schlitze 3 des ersten Solarzellenträgers 1 und der Schlitze 3 des zweiten Solarzellenträgers 1a sind die Oberseiten der beiden Solarzellenträger in derselben Ebene E angeordnet, wie aus Figur 11 ersichtlich ist.

Die beiden Endabschnitte des ersten Solarzellenträgers 1 und die beiden Endabschnitte des zweiten Solarzellenträgers 1a sind jeweils in einer Aussparung 25 des Sockels 22 angeordnet. Dabei ist jeder der beiden Solarzellenträger 1, 1a mit dem ersten elektrischen Anschluss 6 mit der ersten Vertikalleitung 27 und mit dem zweiten elektrischen Anschluss 7 mit der zweiten Vertikalleitung 37 jeweils elektrisch verbunden.

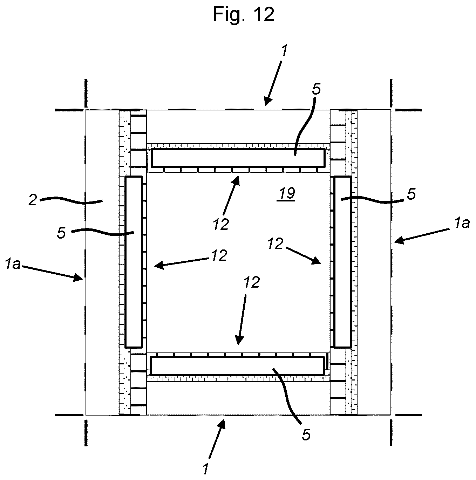

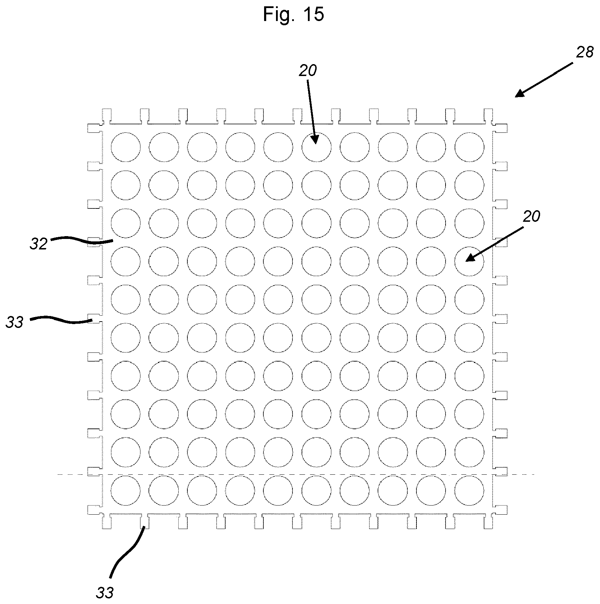

Fig. 12 zeigt eine vergrößerte Darstellung eines durch Solarzellenträger 1, 1a begrenzten Hohlraums 19. Der Hohlraum 19 wird in tangentialer Richtung durch zwei erste Solarzellenträger 1 und zwei zweite Solarzellenträger 1a begrenzt. In axialer Richtung wird der Hohlraum 19 durch den in Figur 7 ersichtlichen Sockelboden 23 begrenzt. Darüber hinaus wird der Hohlraum 19 in axialer Richtung durch die in Fig. 15 gezeigte Lichtverteileinrichtung 28 begrenzt.

Die beiden ersten Solarzellenträger 1 sind parallel zueinander angeordnet. Gleichermaßen sind die beiden zweiten Solarzellenträger 1a parallel zueinander angeordnet. Die mechanische Verbindung zwischen dem ersten Solarzellenträger 1 und dem zweiten Solarzellenträger erfolgt, indem der zweite Solarzellenträger in die Schlitze 3 der beiden ersten Solarzellenträger 1 eingesteckt wird.

Die den Hohlraum 19 umschließende Mantelfläche wird durch das Trägerelement 2, insbesondere den Trägerelementbereich 12, des Solarzellenträgers 1, 1a gebildet. Da an jedem Trägerelementbereich 12 eine Solarzelle 5 angeordnet ist, können mehrere Solarzellen 5 mit Licht beaufschlagt werden, wenn Licht in den Hohlraum 19 eingebracht wird.

Fig. 12 zeigt eine vergrößerte Darstellung eines durch Solarzellenträger 1, 1a begrenzten Hohlraums 19 und Fig. 13 zeigt einen Lichtstrahlverlauf durch den Hohlraum. Wie aus Figur 13 ersichtlich ist, weist die Solarzelle 5 einen mehrschichtigen Aufbau auf. So weist die Solarzelle 5 eine erste Elektrode 38, eine weitere Schicht 39 auf, die aus einem elektronisch organischen Material besteht. Darüber hinaus weist die Solarzelle 5 eine zweite Elektrode 40 auf. Die zweite Elektrode 40 kann aus einer elektrisch leitfähigen TCO-Beschichtung bestehen, die auf die reflektierende Schicht 10 aufgebracht ist. Die erste Elektrode 38 kann eine transparente Folie sein, die eine elektrisch leitfähige Gitterstruktur aufweisen kann, durch deren Hohlräume Licht auf die weitere Schicht 39, nämlich das elektrisch-organische Material dringen, kann.

Die Schutzschicht 14 ist an die erste Elektrode 38 angebracht. Die erste Elektrode 38 ist an die weitere Schicht und die weitere Schicht ist an die zweite Elektrode 40 angebracht. Die zweite Elektrode 40 ist bei der dargestellten Ausführung Bestandteil der oben beschriebenen elektrisch leitfähigen Schicht 35 und/oder integral mit der elektrisch leitfähigen Schicht 35 ausgebildet. Die weitere Schicht 39 und die erste Elektrode 38 sind in Längsrichtung L in Streifen in regelmäßigen Abständen auf der reflektierenden Schicht 10 angebracht, sodass ein Zwischenraum zwischen den Streifen entsteht, der keine photovoltaische Oberfläche aufweist und als Fläche für das Ineinanderstecken der Trägerelemente 2 reserviert ist. Insbesondere sind die weitere Schicht 39 und die erste Elektrode 38 nur in den Trägerelementbereichen 12 angeordnet.

Ein Lichtstrahl 41 tritt durch eine Öffnung 42 in den Hohlraum 19 ein und wird teilweise von der Schutzschicht 14 reflektiert. Der nicht reflektierte Lichtstrahl gelangt in die semi-transparente organische Solarzelle 5 und wird dort teilweise absorbiert. Der nicht absorbierte Lichtstrahl wird von der am Trägermedium 2 angebrachten reflektierenden Schicht 10 reflektiert und tritt aus der Schutzschicht 14 aus. Dieser Vorgang erfolgt mehrmals im Hohlraum 19. Im Ergebnis wird der nicht absorbierte Teil des Lichtes in der Photovoltaikvorrichtung 18 gehalten.

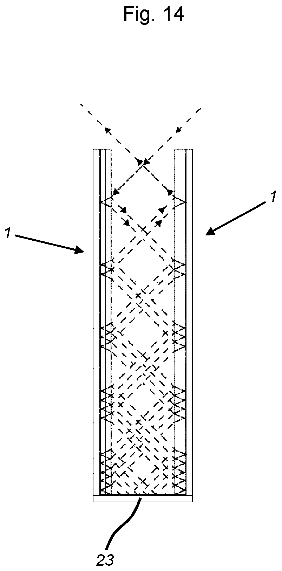

Fig. 14 zeigt den Lichtstrahlverlauf durch den Hohlraum 19. Der Lichtstrahl 41 wird von dem reflektierenden Sockelboden 23 umgelenkt, sodass er in umgekehrter Richtung verläuft und in zuvor beschriebener Weise in die Schutzschicht 14 und zu den Solarzellen 5 gelangt. Die Öffnung 42 weist eine kleinere Öffnungsfläche auf als die durch die Solarzellen 1, 1a, die mit in den Hohlraum 19 eingebrachten Licht beaufschlagt wird, bereitgestellte photovoltaisch nutzbare Fläche.

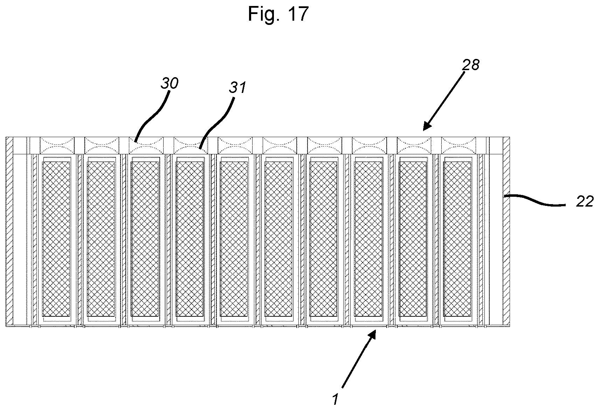

Fig. 15 zeigt eine Draufsicht auf eine Lichtverteileinrichtung 28. Die Lichtverteileinrichtung 28 weist eine Linsenhalterung 32 mit einer Vielzahl von Linsenabschnitten 20 auf. Die Linsenabschnitte 20 sind derart platziert, dass, wie aus Fig. 17 ersichtlich ist, bei einem Aufsetzen der Lichtverteileinrichtung 28 auf die Solarzellenträger 1, 1a, die Linsenabschnitte 20 oberhalb des Hohlraums 19 angeordnet sind. Die Linsenabschnitte 20 sind koaxial zu dem Hohlraum 19 angeordnet. Somit kann über die Linsenabschnitte 20, das in die Lichtverteileinrichtung 28 eingebrachte Licht, insbesondere Sonnenlicht, in den Hohlraum 19 eingebracht werden.

Die Lichtverteileinrichtung 28 kann mehrere Halteabschnitte 33 aufweisen, die seitlich von der Linsenhalterung 32 vorstehen. Die Halteabschnitte 33 sind derart positioniert und/oder ausgebildet, dass jeweils ein Halteabschnitt 33 in die Aussparung 25 eingebracht werden kann.

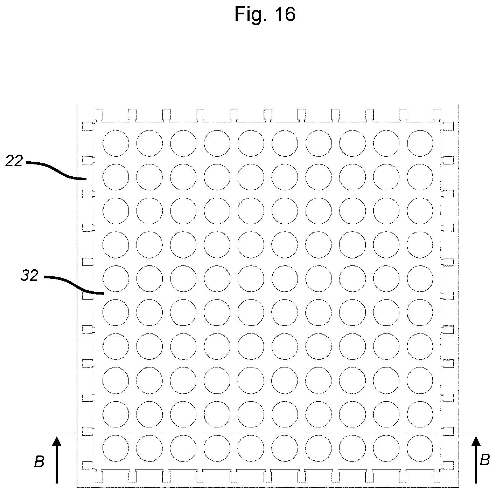

Fig. 16 zeigt eine Draufsicht auf die Photovoltaikvorrichtung 18 mit eingebauter Lichtverteileinrichtung 28. Fig. 17 zeigt eine Seitenschnittansicht entlang einer Linie B-B aus Fig. 16.

Der Lichtabschnitt 20 weist jeweils eine Sammellinse 30 und eine Streulinse 31 auf. Die Sammellinse 30 dient zum Sammeln des in die Lichtverteileinrichtung 28 eingebrachten Lichts. Die Streulinse 31 dient zum Streuen des durch die Sammellinse 30 gesammelten Lichts in den Hohlraum 19 hinein. Die beiden Linsen 30, 31 sind einstückig mit der Linsenhalterung 32 ausgebildet. Die Lichtverteileinrichtung 28 deckt die Solarzellenträger 1, 1a vollständig ab. Darüber hinaus ist die Lichtverteileinrichtung 28 derart ausgebildet, dass sie bündig mit dem Sockel 22 ist.

Fig. 18 zeigt eine perspektivische Darstellung der Photovoltaikvorrichtung 18 mit eingebauter Lichtverteileinrichtung 28 gemäß einer weiteren Ausführung. Die Photovoltaikvorrichtung 18 unterscheidet sich von der zuvor beschriebenen Photovoltaikvorrichtung lediglich darin, dass die Lichtverteileinrichtung 28 nicht bündig zu dem Sockel 22 angeordnet ist. Die Lichtverteileinrichtung 28 ist auf den Sockel 22 gesetzt und somit nur teilweise in dem Innenraum 19 des Sockels 22 angeordnet.

### Bezugszeichen

- 1: erster Solarzellenträger
- 1a: zweiter Solarzellenträger
- 2: Trägerelement
- 3: Schlitz
- 4: Trägerelementseite
- 5: Solarzelle
- 6: erster elektrischer Anschluss
- 7: zweiter elektrischer Anschluss
- 8: Abnehmer von elektrischer Energie
- 10: reflektierende Schicht
- 11: gegenüberliegende Trägerelementseite
- 12: Trägerelementbereich
- 13: andere Solarzelle
- 14: Schutzschicht
- 15: anderes Trägerelement
- 16: andere Trägerelementseite
- 18: Photovoltaikvorrichtung
- 19: Hohlraum
- 20: Linsenaufnahme
- 21: Überkreuzungsstelle
- 22: Sockel
- 23: Sockelboden
- 24: Sockelwand
- 25: Aussparung
- 26: erste Bodenleitung
- 27: erste Vertikalleitung
- 28: Lichtverteileinrichtung
- 29: Innenraum
- 30: Sammellinse
- 31: Streulinse
- 32: Linsenhalterung
- 33: Halteabschnitt
- 34: Endbereich
- 35: elektrisch leitfähige Schicht
- 36: zweite Bodenleitung
- 37: zweite Vertikalleitungen
- 38: erste Elektrode
- 39: weitere Schicht
- 40: zweite Elektrode
- 41: Lichtstrahl
- 42: Öffnung

- B: Breitenrichtung
- E: Ebene
- L: Längsrichtung
- H: Höhenrichtung

## Patentansprüche

1. Solarzellenträger (1, 1a) mit
wenigstens einem Trägerelement (2), das wenigstens einen Schlitz (3) aufweist, in dem ein anderes Trägerelement (2) eines anderen Solarzellenträgers (1, 1a) anordenbar ist,
wenigstens einer an einer Trägerelementseite (4) angebrachten Solarzelle (5) und
wenigstens einem mit der wenigstens einen Solarzelle (5) elektrisch verbundenen elektrischen Anschluss (6, 7) zum elektrischen Verbinden des Solarzellenträgers (1) mit einem Abnehmer (8) von elektrischer Energie.

2. Solarzellenträger (1, 1a) nach Anspruch 1, **dadurch gekennzeichnet, dass**
a. der wenigstens eine elektrische Anschluss (6, 7) an einem Ende des Trägerelements (2) angeordnet ist oder dass der Solarzellenträger (1) zwei elektrische Anschlüsse (6, 7) aufweist, wobei ein erster elektrischer Anschluss (6) an einem ersten Ende des Trägerelements (2) und ein zweiter elektrischer Anschluss (7) an einem zweiten Ende des Trägerelements (2) angeordnet ist und/oder dass
b. sich das Trägerelement (2) entlang einer Längsrichtung (L) und einer Höhenrichtung (H) erstreckt, wobei der elektrische Anschluss (6, 7) an einem Ende des Trägerelements (2) angeordnet ist und sich über die gesamte Höhe des Endes des Trägerelements (2) erstreckt.

3. Solarzellenträger (1, 1a) nach Anspruch 1 oder 2, **dadurch gekennzeichnet, dass** der Solarzellenträger (1, 1a) mehrere Trägerelemente (2, 15) aufweist.

4. Solarzellenträger (1, 1a) nach Anspruch 3, **dadurch gekennzeichnet, dass**
a. das Trägerelement (2) mit einem anderem Trägerelement (15) fest verbunden ist und/oder dass
b. eine zur Trägerelementseite (4) gegenüberliegende Trägerelementseite (11) an einer anderen Trägerelementseite (16) anliegt und/oder dass
c. das Trägerelement (2) und ein anderes Trägerelement (15) derart miteinander verbunden sind, dass ein Schlitz (3) des Trägerelements (2) mit einem anderen Schlitz des anderen Trägerelements (15) fluchtet.

5. Solarzellenträger (1, 1a) nach einem der Ansprüche 1 bis 4, **dadurch gekennzeichnet, dass** der Solarzellenträger (1, 1a) eine andere Solarzelle (13) aufweist, die an einer der Trägerelementseite (4) gegenüberliegenden Trägerelementseite (11) angeordnet ist.

6. Photovoltaikvorrichtung (18) mit mehreren Solarzellenträgern (1) jeweils nach einem der Ansprüche 1 bis 5, die miteinander verbunden sind.

7. Photovoltaikvorrichtung (18) nach einem Anspruch 6, **dadurch gekennzeichnet, dass**
a. an wenigstens einer Überkreuzungsstelle (21) von jeweils zwei Solarzellenträgern (1, 1a) jeder der Solarzellenträger (1, 1a) derart angeordnet ist, dass der Schlitz (3) des jeweiligen Solarzellenträgers (1, 1a) mit seinem offenen Ende in Richtung zum anderen Solarzellenträger (1, 1a) weist und/oder dass
b. die Solarzellenträger (1, 1a), insbesondere ein erster Solarzellenträger (1) und ein zweiter Solarzellenträger (1a), kreuzweise miteinander verbunden sind und/oder dass
c. an einer Überkreuzungsstelle (21) die beiden Solarzellenträger (1, 1a) rechtwinklig überkreuzt angeordnet sind und/oder dass
d. die Solarzellenträger (1, 1a) im verbundenen Zustand eine Gitterstruktur bilden.

8. Photovoltaikvorrichtung (18) nach Anspruch 6 oder 7, **dadurch gekennzeichnet, dass** mehrere, insbesondere wenigstens drei, vorzugsweise genau vier, Solarzellenträger (1, 1a) einen Hohlraum (19) begrenzen.

9. Photovoltaikvorrichtung (18) nach einem der Ansprüche 6 bis 8, **dadurch gekennzeichnet, dass** eine Öffnungsfläche einer Öffnung (42) eines Hohllichtleiters (20), durch die Licht in den Hohlraum (19) einbringbar ist, kleiner ist als eine den Hohlraum (19) umschließende Mantelfläche und/oder als eine photovoltaisch nutzbare Fläche.

10. Photovoltaikvorrichtung (18) nach einem der Ansprüche 6 bis 9, **dadurch gekennzeichnet, dass** die Photovoltaikvorrichtung (18) einen, insbesondere quaderförmigen, Sockel (22) zum Halten der Solarzellenträger (1, 1a) aufweist.

11. Photovoltaikvorrichtung (18) nach Anspruch 10, **dadurch gekennzeichnet, dass** der Sockel (22) eine Sockelwand (24) und mehrere Aussparungen (25) zum Aufnehmen des Solarzellenträgers (1) aufweist, die in der Sockelwand (24) angeordnet sind.

12. Photovoltaikvorrichtung (18) nach Anspruch 11, **dadurch gekennzeichnet, dass**
a. die Aussparung (25) eine elektrische Leitung des Abnehmers (8) aufweist und/oder dass
b. der elektrische Abschnitt (6, 7) des Solarzellenträger (1, 1a) in der Aussparung (25) angeordnet ist und/oder dass
c. ein erster elektrischer Abschnitt (6) des Solarzellenträgers (1, 1a) in einer ersten Aussparung und ein zweiter elektrischer Abschnitt (7) des Solarzellenträgers (1, 1a) in einer zweiten Aussparung angeordnet ist, wobei sich die erste Aussparung und die zweite Aussparung gegenüberliegen.

13. Photovoltaikvorrichtung (18) nach einem der Ansprüche 6 bis 12, **dadurch gekennzeichnet, dass** die Photovoltaikvorrichtung (18) eine Lichtverteileinrichtung (28) aufweist, die
a. auf die Solarzellenträger (1, 1a) gesetzt ist und/oder die
b. in einem Innenraum (29) eines Sockels (22) eingesetzt ist.

14. Verfahren zum Herstellen einer Photovoltaikvorrichtung (18) nach einem der Ansprüche 6 bis 13, **dadurch gekennzeichnet, dass**
wenigstens ein erster Solarzellenträger (1) nach einem der Ansprüche 1 bis 14 in einen Innenraum (29) eines Sockels (22) der Photovoltaikvorrichtung (18) eingesetzt wird und
wenigstens ein zweiter Solarzellenträger (1a) nach einem der Ansprüche 1 bis 14 mit dem ersten Solarzellenträger (1) verbunden wird.

15. Verwendung eines Solarzellenträgers (1, 1a) nach einem der Ansprüche 1 bis 5 in einer Photovoltaikvorrichtung (18), insbesondere nach einem der Ansprüche 6 bis 13.

## Claims

1. A solar cell support (1, 1a) having
at least one support element (2) having at least one slot (3), in which another support element (2) of another solar cell support (1, 1a) can be arranged,
at least one solar cell (5) attached to a support element side (4) and
at least one electrical connection (6, 7) electrically connected to the at least one solar cell (5) for electrically connecting the solar cell support (1) to a consumer (8) of electrical energy.

2. The solar cell support (1, 1a) according to claim 1, **characterised in that**
a. the at least one electrical connection (6, 7) is arranged at one end of the support element (2) or that the solar cell support (1) has two electrical connections (6, 7), wherein a first electrical connection (6) is arranged at a first end of the support element (2) and a second electrical connection (7) is arranged at a second end of the support element (2) and/or that
b. the support element (2) extends along a longitudinal direction (L) and a height direction (H), wherein the electrical connection (6, 7) is arranged at one end of the support element (2) and extends over the entire height of the end of the support element (2).

3. The solar cell support (1, 1a) according to claim 1 or 2, **characterised in that** the solar cell support (1, 1a) has a plurality of support elements (2, 15).

4. The solar cell support (1, 1a) according to claim 3, **characterised in that**
a. the support element (2) is firmly connected to another support element (15) and/or that
b. a support element side (11) opposite the support element side (4) abuts another support element side (16) and/or that
c. the support element (2) and another support element (15) are connected to each other such that a slot (3) of the support element (2) is aligned with another slot of the other support element (15).

5. The solar cell support (1, 1a) according to any one of claims 1 to 4, **characterised in that** the solar cell support (1, 1a) has another solar cell (13) which is arranged on a support element side (11) opposite the support element side (4).

6. A photovoltaic device (18) having a plurality of solar cell supports (1), each according to any one of claims 1 to 5, which are connected to each other.

7. The photovoltaic device (18) according to claim 6, **characterised in that**
a. at at least one intersection point (21) between two respective solar cell supports (1, 1a), each of the solar cell supports (1, 1a) is arranged such that the slot (3) of the respective solar cell support (1, 1a) has its open end facing toward the other solar cell support (1, 1a) and/or that
b. the solar cell supports (1, 1a), in particular a first solar cell support (1) and a second solar cell support (1a), are connected crosswise to each other and/or that
c. at an intersection point (21), the two solar cell supports (1, 1a) are arranged crossing each other at right angles and/or that
d. the solar cell supports (1, 1a) form a lattice structure when connected.

8. The photovoltaic device (18) according to claim 6 or 7, **characterised in that** a plurality of, in particular at least three, preferably exactly four, solar cell supports (1, 1a) delimit a cavity (19).

9. The photovoltaic device (18) according to any one of claims 6 to 8, **characterised in that** an opening area of an opening (42) of a hollow light guide (20), through which opening light can be introduced into the cavity (19), is smaller than a lateral surface enclosing the cavity (19) and/or than a photovoltaically usable area.

10. The photovoltaic device (18) according to any one of claims 6 to 9, **characterised in that** the photovoltaic device (18) has a base (22), in particular cuboid in shape, for holding the solar cell supports (1, 1a).

11. The photovoltaic device (18) according to claim 10, **characterised in that** the base (22) has a base wall (24) and a plurality of recesses (25) for receiving the solar cell support (1), which are arranged in the base wall (24).

12. The photovoltaic device (18) according to claim 11, **characterised in that**
a. the recess (25) has an electrical line of the consumer (8) and/or that
b. the electrical section (6, 7) of the solar cell support (1, 1a) is arranged in the recess (25) and/or that
c. a first electrical section (6) of the solar cell support (1, 1a) is arranged in a first recess and a second electrical section (7) of the solar cell support (1, 1a) is arranged in a second recess, wherein the first recess and the second recess are opposite each other.

13. The photovoltaic device (18) according to any one of claims 6 to 12, **characterised in that** the photovoltaic device (18) has a light distribution device (28) which
a. is placed on the solar cell supports (1, 1a) and/or which
b. is inserted into an interior space (29) of a base (22).

14. A method for producing a photovoltaic device (18) according to any one of claims 6 to 13, **characterised in that**
at least one first solar cell support (1) according to any one of claims 1 to 14 is inserted into an interior space (29) of a base (22) of the photovoltaic device (18) and
at least one second solar cell support (1a) according to any one of claims 1 to 14 is connected to the first solar cell support (1).

15. Use of a solar cell support (1, 1a) according to any one of claims 1 to 5 in a photovoltaic device (18), in particular according to any one of claims 6 to 13.

## Revendications

1. Support de cellule solaire (1, 1a) comprenant
au moins un élément de support (2) comportant au moins une fente (3) dans laquelle peut être disposé un autre élément de support (2) d'un autre support de cellule solaire (1, 1a),
au moins une cellule solaire (5) fixée sur un côté d'élément de support (4) et
au moins une borne électrique (6, 7) reliée électriquement à la ou les cellules solaires (5) pour relier électriquement le support de cellule solaire (1) à un consommateur (8) d'énergie électrique.

2. Support de cellule solaire (1, 1a) selon la revendication 1, **caractérisé en ce que**
a. au moins la ou les bornes électriques (6, 7) sont disposées à une extrémité de l'élément de support (2) ou **en ce que** le support de cellule solaire (1) comporte deux bornes électriques (6, 7), une première borne électrique (6) étant agencée à une première extrémité de l'élément de support (2) et une seconde borne électrique (7) étant agencée à une seconde extrémité de l'élément de support (2) et/ou **en ce que**
b. l'élément de support (2) s'étend dans une direction longitudinale (L) et dans une direction verticale (H), la borne électrique (6, 7) étant agencée à une extrémité de l'élément de support (2) et s'étendant sur toute la hauteur de l'extrémité de l'élément de support (2).

3. Support de cellule solaire (1, 1a) selon la revendication 1 ou 2, **caractérisé en ce que** le support de cellule solaire (1, 1a) comporte plusieurs éléments de support (2, 15).

4. Support de cellule solaire (1, 1a) selon la revendication 3, **caractérisé en ce que**
a. l'élément de support (2) est solidement relié à un autre élément de support (15) et/ou **en ce que**
b. un côté d'élément de support (11) opposé au côté d'élément de support (4) est adjacent à un autre côté d'élément de support (16) et/ou **en ce que**
c. l'élément de support (2) et un autre élément de support (15) sont reliés l'un à l'autre de telle sorte qu'une fente (3) de l'élément de support (2) soit alignée avec une autre fente de l'autre élément de support (15).

5. Support de cellule solaire (1, 1a) selon l'une des revendications 1 à 4, **caractérisé en ce que** le support de cellule solaire (1, 1a) comporte une autre cellule solaire (13) qui est disposée sur un côté d'élément de support (11) opposé au côté d'élément de support (4).

6. Dispositif photovoltaïque (18) comprenant plusieurs supports de cellules solaires (1) chacun selon l'une des revendications 1 à 5, qui sont reliés les uns aux autres.

7. Dispositif photovoltaïque (18) selon la revendication 6, **caractérisé en ce que**
a. au niveau d'au moins un point d'intersection (21) de chaque paire de supports de cellules solaires (1, 1a), chaque support de cellule solaire (1, 1a) est agencé de telle sorte que la fente (3) de chaque support de cellule solaire (1, 1a) est orientée, avec son extrémité ouverte, en direction de l'autre support de cellule solaire (1, 1a) et/ou **en ce que**
b. les supports de cellules solaires (1, 1a), en particulier un premier support de cellule solaire (1) et un second support de cellule solaire (1a), sont reliés en croix l'un à l'autre et/ou **en ce que**
c. au point d'intersection (21), la paire de supports de cellules solaires (1, 1a) est agencée à angle droit l'un par rapport à l'autre et/ou **en ce que**
d. les supports de cellules solaires (1, 1a) forment une structure en réseau lorsqu'ils sont reliés.

8. Dispositif photovoltaïque (18) selon la revendication 6 ou 7, **caractérisé en ce que** plusieurs, en particulier au moins trois, de préférence exactement quatre, supports de cellules solaires (1, 1a) délimitent une cavité (19).

9. Dispositif photovoltaïque (18) selon l'une des revendications 6 à 8, **caractérisé en ce qu'**une surface d'ouverture d'une ouverture (42) d'un guide de lumière creux (20), à travers laquelle la lumière peut être introduite dans la cavité (19), est plus petite qu'une surface entourant la cavité (19) et/ou qu'une surface utilisable à des fins photovoltaïques.

10. Dispositif photovoltaïque (18) selon l'une des revendications 6 à 9, **caractérisé en ce que** le dispositif photovoltaïque (18) comporte un socle (22), en particulier de forme cubique, destiné à contenir les supports de cellules solaires (1, 1a).

11. Dispositif photovoltaïque (18) selon la revendication 10, **caractérisé en ce que** le socle (22) comporte une paroi de socle (24) et plusieurs évidements (25) destinés à recevoir le support de cellule solaire (1) qui sont agencés dans la paroi de socle (24).

12. Dispositif photovoltaïque (18) selon la revendication 11, **caractérisé en ce que**
a. l'évidement (25) comporte un conducteur électrique du consommateur (8) et/ou **en ce que**
b. la section électrique (6, 7) du support de cellule solaire (1, 1a) est agencée dans l'évidement (25) et/ou **en ce que**
c. une première section électrique (6) du support de cellule solaire (1, 1a) est agencée dans un premier évidement et une seconde section électrique (7) du support de cellule solaire (1, 1a) est agencée dans un second évidement, le premier évidement et le second évidement étant opposés l'un à l'autre.

13. Dispositif photovoltaïque (18) selon l'une des revendications 6 à 12, **caractérisé en ce que** le dispositif photovoltaïque (18) comporte un dispositif répartiteur de lumière (28) qui
a. est placé sur les supports de cellules solaires (1, 1a) et/ou qui
b. est inséré dans un espace intérieur (29) d'un socle (22).

14. Procédé de fabrication d'un dispositif photovoltaïque (18) selon l'une des revendications 6 à 13, **caractérisé en ce que**
au moins un premier support de cellule solaire (1) selon l'une des revendications 1 à 14 est inséré dans un espace intérieur (29) d'un socle (22) du dispositif photovoltaïque (18) et
au moins un second support de cellule solaire (1a) selon l'une des revendications 1 à 14 est relié au premier support de cellule solaire (1).

15. Utilisation d'un support de cellule solaire (1, 1a) selon l'une des revendications 1 à 5 dans un dispositif photovoltaïque (18), en particulier selon l'une des revendications 6 à 13.
